# EUROPEAN PATENT APPLICATION

(11) **EP 4 608 095 A2**
(43) Date of publication of application: **27.08.2025**
(21) Application number: 25157951.2
(22) Date of filing: 14.02.2025
(51) Int. Cl.: H10D 89/10, H10D 84/90, G06F 30/392, H10D 84/85, H10D 30/43

(54) **FILLER CELL FOR CELL LAYOUT FOR SEMICONDUCTOR DEVICE**

(30) Priority: 26.02.2024 US 202463557912 P; 12.07.2024 US 202418771303
(71) Applicant: Samsung Electronics Co., Ltd., Suwon-si, Gyeonggi-do 16677 (KR)
(72) Inventor: KIM, Jintae, San Jose, 95134 (US); SHIN, Hyo Jong, San Jose, 95134 (US)
(74) Representative: Kuhnen & Wacker Patent- und Rechtsanwaltsbüro PartG mbB

(57) **Abstract**

A cell layout for a semiconductor device is provided, comprising: a 1^{st} cell; a 2^{nd} cell at a side of the 1^{st} cells in a 1^{st} direction; and a filler cell between the 1^{st} cell and the 2^{nd} cell, wherein the 2^{nd} cell has a form of a flipped cell of the 1^{st} cell in a 2^{nd} direction which intersects the 1^{st} direction, wherein each of the 1^{st} cell, the filler cell, and the 2^{nd} cell comprises a 1^{st} active pattern and a 2^{nd} active pattern above the 1^{st} active pattern in a 3^{rd} direction which intersects the 1^{st} direction and the 2^{nd} direction, wherein the 2^{nd} active pattern of the 1^{st} cell and the 2^{nd} active pattern of the 2^{nd} cell are partially overlapped or not overlapped in the 1^{st} direction, and wherein each of the 2^{nd} active pattern of the 1^{st} cell and the 2^{nd} active pattern of the 2^{nd} cell is entirely overlapped by the 2^{nd} active pattern of the filler cell in the 1^{st} direction.

## Description

### BACKGROUND

### 1. Filed

Apparatuses consistent with example embodiments of the disclosure relate to a filler cell for a cell layout for a semiconductor device.

### 2. Description of Related Art

A semiconductor device for an integrated circuit includes a plurality of logic circuits which perform one or more logic operations or functions such as AND, OR, NOT (inverter), NAND, NOR, XOR, XNOR, AOI, multiplexing, and their combination, not being limited thereto. These logic circuits are a building block of the integrated circuit, and may be implemented in one or more semiconductor cells or a semiconductor cell block. Hereafter, a semiconductor cell implementing the logic circuit is referred to as a cell, a function cell or a standard cell stored in a cell library used in designing a semiconductor device for an integrated circuit.

In designing a semiconductor device, a plurality of cells may be selected from the cell library and disposed in selected positions on a cell layout for the semiconductor device. At this time, an empty region may be generated between two cells arranged in one direction, by which one or more active patterns in one cell are disconnected from one or more active patterns from a neighboring cell, and gate line arrangement in a predetermined contact-poly-pitch (CPP) in the cell layout may be disrupted. This empty region violates a cell design rule which is complied with to ensure proper dispositions of cells with respect to other circuit elements such as active patterns, gate structures, metal lines, power rails, etc. Thus, a filler cell may be disposed in the empty region between the two cells at least to comply with the cell design rule, for example, to provide continuity of active patterns between the two separated cells and gate line arrangement in the predetermined CPP. However, the filler cell is not a function cell but a dummy cell or a dummy region even where one or more active patterns and one or more gate lines formed therein do not form or function as a transistor.

Filler cells are also used in designing a cell layout for a three-dimensional-stacked (3D-stacked) semiconductor device which includes a 1^{st} transistor at a 1^{st} level and a 2^{nd} transistor at a 2^{nd} level above the 1^{st} level. The transistors forming the 3D-stacked semiconductor device may be a fin field-effect transistor (FinFET), a nanosheet transistor also referred to as gate-all-around (GAA) transistor or a multi-bridge channel field-effect transistor (MBCFET), a forksheet transistor, or any other type of transistor, or a combination thereof. However, designing a filler cell for the cell layout for the 3D-stacked semiconductor device may be more complicated and require more considerations than those for a plain two-dimensional (2D) semiconductor device.

Filler cells affect performance of a 3D-stacked semiconductor device formed based on a cell layout including the filler cells. Thus, how to design or form filler cells for a cell layout for a 3D-stacked semiconductor device has been actively studied in the field.

Information disclosed in this Background section has already been known to the inventors before achieving the embodiments of the present application or is technical information acquired in the process of achieving the embodiments described herein. Therefore, it may contain information that does not form prior art that is already known to the public.

### SUMMARY

Various example embodiments provide a cell layout or a cell block for a semiconductor device in which a uniform filler cell is formed to connect two cells.

According to one or more embodiments, there is provided a cell layout for a semiconductor device, which may include: a 1^{st} cell; a 2^{nd} cell at a side of the 1^{st} cells in a 1^{st} direction; and a filler cell between the 1^{st} cell and the 2^{nd} cell, wherein the 2^{nd} cell has a form of a flipped cell of the 1^{st} cell in a 2^{nd} direction which intersects the 1^{st} direction, wherein each of the 1^{st} cell, the filler cell, and the 2^{nd} cell includes a 1^{st} active pattern and a 2^{nd} active pattern above the 1^{st} active pattern in a 3^{rd} direction which intersects the 1^{st} direction and the 2^{nd} direction, wherein the 2^{nd} active pattern of the 1^{st} cell and the 2^{nd} active pattern of the 2^{nd} cell are partially overlapped or not overlapped in the 1^{st} direction, and wherein each of the 2^{nd} active pattern of the 1^{st} cell and the 2^{nd} active pattern of the 2^{nd} cell is entirely overlapped by the 2^{nd} active pattern of the filler cell in the 1^{st} direction.

According to one or more embodiments, there is provided a cell layout for a semiconductor device, which may include: a 1^{st} cell; a 2^{nd} cell at a side of the 1^{st} cells in a 1^{st} direction; and a filler cell between the 1^{st} cell and the 2^{nd} cell, wherein each of the 1^{st} cell, the filler cell, and the 2^{nd} cell includes a 1^{st} active pattern and a 2^{nd} active pattern above the 1^{st} active pattern in a 3^{rd} direction which intersects the 1^{st} direction, and wherein a width the 2^{nd} active pattern in the filler cell is greater than each of a width of the 2^{nd} active pattern in the 1^{st} cell and a width of the 2^{nd} active pattern in the 2^{nd} cell, in a 2^{nd} direction intersecting the 1^{st} direction and the 3^{rd} direction.

According to one or more embodiments, there is provided a cell layout for a semiconductor device, which may include: a 1^{st} cell; a 2^{nd} cell at a side of the 1^{st} cells in a 1^{st} direction; and a filler cell between the 1^{st} cell and the 2^{nd} cell, wherein each of the 1^{st} cell, the filler cell, and the 2^{nd} cell includes a 1^{st} active pattern and a 2^{nd} active pattern above the 1^{st} active pattern in a 3^{rd} direction, and wherein a width of the 2^{nd} active pattern and a width of the 1^{st} active pattern are the same in the filler cell, in a 2^{nd} direction intersecting the 1^{st} direction and the 3^{rd} direction.

### BRIEF DESCRIPTION OF DRAWINGS

Example embodiments of the disclosure will be more clearly understood from the following detailed description taken in conjunction with the accompanying drawings in which:
FIG. 1A illustrates a cell layout including a filler cell for a 3D-stacked semiconductor device, according to one or more embodiments;
FIGS. 1B and 1C illustrate cross-section views of the 3D-stacked semiconductor device manufactured based on the cell layout of FIG. 1A along lines I-I' (III-III' or V-V') and II-II' (or IV-IV' or VI-VI') shown in FIG. 1A, respectively, according to one or more embodiments;
FIG. 2 illustrates a cell layout including a filler cell for a 3D-stacked semiconductor device, according to one or more other embodiments;
FIG. 3 illustrates a cell layout including a filler cell for a 3D-stacked semiconductor device, according to yet one or more other embodiments;
FIG. 4A illustrates a cell layout including a uniform filler cell for a 3D-stacked semiconductor device, according to one or more embodiments;
FIGS. 4B and 4C illustrate cross-section views of the 3D-stacked semiconductor device manufactured based on the cell layout of FIG. 4A along lines III-III' and IV-IV' shown in FIG. 4A, respectively, according to one or more embodiments;
FIG. 5 illustrates a cell layout including a uniform filler cell for a 3D-stacked semiconductor device, according to still one or more other embodiments;
FIG. 6 illustrates a cell layout including a uniform filler cell for a 3D-stacked semiconductor device, according to yet one or more other embodiments; and
FIG. 7 is a schematic block diagram illustrating an electronic device including at least one 3D-stacked semiconductor device formed based on at least one of the cell layouts or cell blocks 40, 50 and 60 shown in FIGS. 4A, 5 and 6, respectively, according to one or more embodiments.

### DETAILED DESCRIPTION

The embodiments of the disclosure described herein are example embodiments, and thus, the disclosure is not limited thereto, and may be realized in various other forms. Each of the embodiments provided in the following description is not excluded from being associated with one or more features of another example or another embodiment also provided herein or not provided herein but consistent with the disclosure. For example, even if matters described in a specific example or embodiment are not described in a different example or embodiment thereto, the matters may be understood as being related to or combined with the different example or embodiment, unless otherwise mentioned in descriptions thereof. In addition, it should be understood that all descriptions of principles, aspects, examples, and embodiments of the disclosure are intended to encompass structural and functional equivalents thereof. In addition, these equivalents should be understood as including not only currently well-known equivalents but also equivalents to be developed in the future, that is, all devices invented to perform the same functions regardless of the structures thereof.

It will be understood that when an element, component, layer, pattern, structure, region, or so on (hereinafter collectively "element") of a semiconductor device is referred to as being "over," "above," "on," "below," "under," "beneath," "connected to" or "coupled to" another element the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present. Like numerals refer to like elements throughout this disclosure.

Spatially relative terms, such as "over," "above," "on," "upper," "below," "under," "beneath," "lower," "left," "right," "lower-left," "lower-right," "upper-left," "upper-right," "central," "middle," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, elements described as "below" or "beneath" other elements would then be oriented "above" the other elements. Thus, the term "below" can encompass both an orientation of above and below. The semiconductor device may be otherwise oriented (rotated 90 degrees or at other orientations) and the spatially relative descriptors used herein interpreted accordingly. As another example, when elements referred to as a "left" element and a "right" element" may be a "right" element and a "left" element when a device or structure including these elements are differently oriented. Thus, in the descriptions herebelow, the "left" element and the "right" element may also be referred to as a "1^{st}" element or a "2^{nd}" element, respectively, as long as their structural relationship is clearly understood in the context of the descriptions. Similarly, the terms a "lower" element and an "upper" element may be respectively referred to as a "1^{st}" element and a "2^{nd}" element with necessary descriptions to distinguish the two elements.

It will be understood that, although the terms "1^{st}," "2^{nd}," "3^{rd}," "4^{th}," "5^{th}," etc. may be used herein to describe various elements, these elements should not be limited by these terms. These terms are only used to distinguish one element from another element. Thus, a 1^{st} element discussed below could be termed a 2^{nd} element without departing from the teachings of the disclosure.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c. Herein, when a term "same" is used to compare a dimension of two or more elements, the term may cover a "substantially same" dimension.

It will be also understood that, even if a certain step or operation of manufacturing an apparatus or structure is described later than another step or operation, the step or operation may be performed later than the other step or operation unless the other step or operation is described as being performed after the step or operation.

Many embodiments are described herein with reference to schematic illustrations of the embodiments (and intermediate structures). As such, variations from the shapes of the illustrations as a result, for example, of manufacturing techniques and/or tolerances, are to be expected. Thus, the embodiments should not be construed as limited to the particular shapes of regions illustrated herein but are to include deviations in shapes that result, for example, from manufacturing. Various regions illustrated in the figures are schematic in nature and their shapes are not intended to illustrate the actual shape of a region of a device and are not intended to limit the scope of the disclosure. Further, in the drawings, the sizes and relative sizes of layers and regions may be exaggerated for clarity.

For the sake of brevity, conventional elements, structures or layers of a semiconductor device including a nanosheet transistor, a forksheet transistor or a FinFET, and materials forming the same may or may not be described in detail herein. For example, a certain isolation layer or structure of a semiconductor device and materials forming the same may be omitted herein when this layer or structure is not related to the novel features of the embodiments.

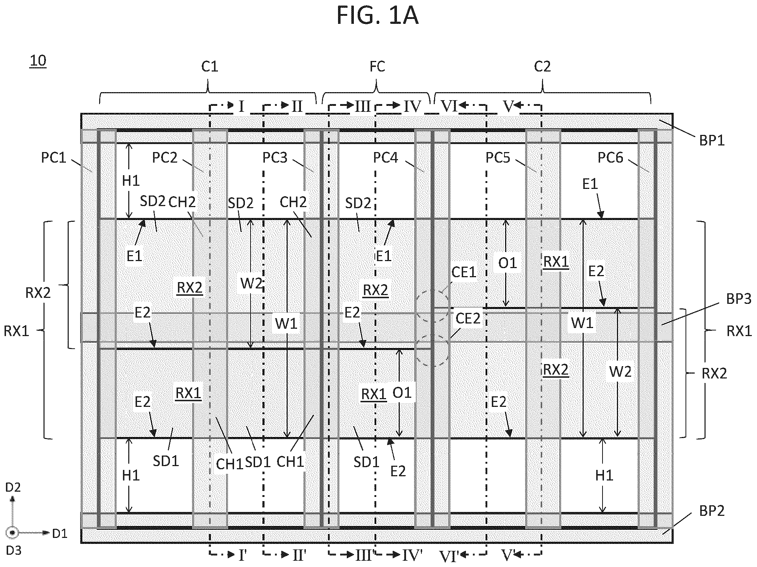

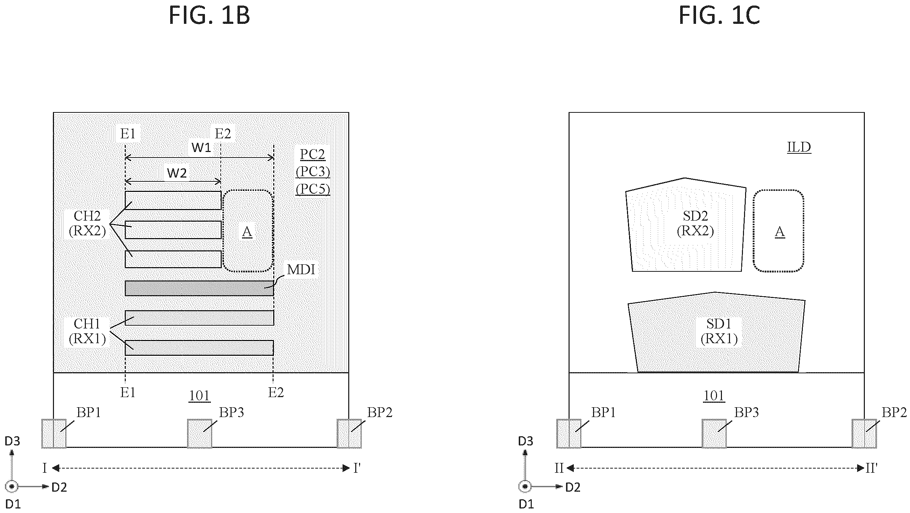

FIG. 1A illustrates a cell layout including a filler cell for a three-dimensional (3D) semiconductor device, according to one or more embodiments. FIGS. 1B and 1C illustrate cross-section views of the 3D-stacked semiconductor device manufactured based on the cell layout of FIG. 1A along lines I-I' (III-III' or V-V') and II-II' (or IV-IV' or VI-VI') shown in FIG. 1A, respectively, according to one or more embodiments.

Referring to FIG. 1A, a cell layout 10 may include a 1^{st} cell C1, a filler cell FC, and a 2^{nd} cell C2 serially arranged in a D1 direction. The 1^{st} cell C1 and the 2^{nd} cell C2 may each be a function cell or a standard cell which forms a logic circuit, for example, an inverter circuit, not being limited thereto. However, the filler cell FC may be a dummy cell or dummy region, as described earlier, that connects the two cells C1 and C2 to facilitate manufacturing a 3D-stacked semiconductor device based on the cell layout 10 and maintain continuity of active patterns, power rails, etc. in the two cells C1 and C2. In the meantime, the 2^{nd} cell C2 may be formed by flipping the 1^{st} cell C1 in a D2 direction. The filler cell FC and the cell flipping of the 1^{st} cell C1 will be described in detail later.

Herein, the D1 direction refers to a channel length direction or active pattern length direction, intersecting the D2 direction which is also referred to as a channel width direction or active pattern width direction. The D1 direction and the D2 direction both may be a horizontal direction intersecting a D3 direction which is a vertical direction. It is appreciated herein that the term "cell layout" and the term "semiconductor device" are interchangeably used as the cell layout is to be manufactured as the semiconductor device.

In the cell layout 10, each of the 1^{st} cell C1, the filler cell FC, and the 2^{nd} cell C2 is defined by 1^{st} to 4^{th} boundaries surrounding the cell. The 1^{st} boundary and the 2^{nd} boundary may face each other in the D2 direction, and the 3^{rd} boundary and the 4^{th} boundary may face each other in the D1 direction. The 1^{st} cell C1 may share the 4^{th} boundary thereof with the filler cell FC, and the 2^{nd} cell C2 may share the 3^{rd} boundary thereof with the filler cell FC. The 1^{st} boundaries of these cells C1, FC and C2 may be aligned with or coplanar in the D1 direction to form a 1^{st} boundary of the cell layout 10, and similarly, the 2^{nd} boundaries of these cells C1, FC and C2 may be aligned with or coplanar in the D1 direction to form a 2^{nd} boundary of the cell layout 10. A distance between the 1^{st} boundary and the 2^{nd} boundary of each cell in the D2 direction defines a cell height of the cell. Herein, the 1^{st} to 4^{th} boundaries may be viewed as upper, lower, left and right boundaries, respectively, in a plan view of the cell layout 10.

At the 1^{st} boundary and the 2^{nd} boundary of the cell layout 10 may be formed a 1^{st} power rail BP1 and a 2^{nd} power rail BP2, respectively, which are extended in the D1 direction and connected to a positive voltage source (VDD) or a negative voltage source or ground (VSS). At a virtual centerline of the cell layout 10 in the D1 direction may be formed a 3^{rd} power rail BP3 connected to VDD or VSS, opposite the voltage source to which the 1^{st} power rail BP1 and the 2^{nd} power rail BP2 are connected. These power rails BP1, BP2 and BP3 may be formed at a level below a bottom surface of 1^{st} active patterns RX1 included in the cell layout 10 which will be described later. Thus, these power rails BP1, BP2 and BP3 may be referred to as backside power distribution network (BSPDN) structures, which will be further described later.

In the cell layout 10, the 1^{st} cell C1, the filler cell FC, and the 2^{nd} cell C2 may each include a 1^{st} active pattern RX1 and a 2^{nd} active pattern RX2 extended in the D1 direction. The 2^{nd} active pattern RX2 may be formed above the 1^{st} active pattern RX1 in the D3 direction to form a semiconductor device manufactured based on the cell layout 10 as a 3D-stacked semiconductor device. For example, the 2^{nd} active pattern RX2 may overlap the 1^{st} active pattern RX1 in the D3 direction. However, as the 1^{st} active pattern RX1 has a width W1 which is greater than a width W2 of the 2^{nd} active pattern RX2, the 1^{st} active pattern RX1 may be not entirely but partially overlapped by the 2^{nd} active pattern RX2 in the D3 direction in each of the 1^{st} cell C1, the filler cell FC, and the 2^{nd} cell C2, which will be further described later in reference to FIGS. 1B and 1C

Across the two active patterns RX1 and RX2 in the cell layout 10 may be formed a plurality of gate structures PC1-PC6 (collectively "PC") arranged at a predetermined CPP and extended in the D2 direction. These gate contact structures PC may surround respective portions of the two active patterns RX1 and RX2 so that each of the surrounded portions may form a channel region of a transistor in a 3D-stacked semiconductor device to be manufactured based on the cell layout 10. Further, two opposite sides, in the D1 direction, of the gate structure PC (not the gate structures overlapping the cell boundaries) in each of the 1^{st} cell C1 and the 2^{nd} cell C2 may form source/drain regions connected by the channel region to form a transistor.

For example, portions of the 1^{st} active pattern RX1 at opposite sides of the gate structure PC2 in the 1^{st} cell C1 may form 1^{st} source/drain regions SD1 connected by a 1^{st} channel region CH1. Thus, the 1^{st} channel region CH1, the gate structure PC2, the 1^{st} source/drain regions SD1 may form a 1^{st} transistor at a 1^{st} level of a 3D-stacked semiconductor device. Similarly, portions of the 2^{nd} active pattern RX2 at opposite sides of the gate structure PC2 in the 1^{st} cell C1 may form 2^{nd} source/drain regions SD2 connected by a 2^{nd} channel region CH2. Thus, the 2^{nd} channel region CH2, the gate structure PC2, the 2^{nd} source/drain regions SD2 may form a 2^{nd} transistor at a 2^{nd} level, above the 1^{st} level in the D3 direction, of the 3D-stacked semiconductor device. The source/drain regions SD1, SD2, and the gate structure PC2 may be respectively connected to the power rails BP1, BP2, BP3, or another circuit element to form a logic circuit. Since the 2^{nd} cell C2 is a flipped cell of the 1^{st} cell C1, the 2^{nd} cell C2 may also include a 1^{st} transistor and a 2^{nd} transistor having the same structural elements as the 1^{st} cell C1 to form a logic circuit.

However, the 1^{st} active pattern RX1 and the 2^{nd} active pattern RX2 in the filler cell FC are dummy regions that are not to be connected to a voltage source or another circuit element other than the 1^{st} active pattern RX1 and the 2^{nd} pact RX2 of the 1^{st} cell C1 and the 2^{nd} cell C2, and thus, do not form functional channel regions, source/drain regions and gate structure and in the 3D-stacked semiconductor device. These active patterns RX1 and RX2 in the filler cells may be formed to connect the 1^{st} active patterns RX1 in the two cells C1 and C2, and connect the 2^{nd} active patterns RX2 in the two cells C1 and C2, in order to at least maintain continuity of the active patterns RX1 and RX2 between the two cells C1 and C2 and facilitate manufacturing the 3D-stacked semiconductor device based on the cell layout 10.

For example, the channel regions CH1 and CH2 surrounded by each of the gate structure PC3 at a 3^{rd} boundary of the filler cell FC and the gate structure PC4 at a 4^{th} boundary of the filler cell FC are not functional because the gate structures PC3 and PC4 are not to be connected to another circuit element or any voltage source to receive a gate input signal. Further, the source/drain regions SD1 and SD2 between the two gate structures PC3 and PC4 in the filler cell FC may also not be connected to a voltage source or any circuit element outside the cell layout 10.

The above-described structural elements of the active patterns RX1 and RX2 including the channel regions CH1, CH2 and source/drain regions SD1, SD2 of a 3D-stacked semiconductor device to be manufactured based on the cell layout 10 may be shown in FIGS. 1B and 1C.

FIGS. 1B and 1C illustrate cross-section views of the active patterns RX1 and RX2 of the 1^{st} cell C1 of the cell layout 10 taken along the lines I-I' and II-II' shown in FIG. 1A, respectively, when a 3D-stacked semiconductor device is formed based on the cell layout 10, according to one or more embodiments.

Referring to FIGS. 1B and 1C, the 1^{st} channel region CH1 formed on the 1^{st} active pattern RX1 may include a plurality of nanosheet layers having the width W1 which is greater than the width W2 of a plurality of nanosheet layers forming the 2^{nd} channel region CH2 formed on the 2^{nd} active pattern RX2 above the 1^{st} active pattern RX1. Further, a 1^{st} side edge E1 of the 2^{nd} channel region CH2 and a 1^{st} side edge E1 of the 1^{st} channel region CH1 facing the 1^{st} boundary of the 1^{st} cell C1 may be aligned or coplanar in the D3 direction. However, a 2^{nd} side edge E2 of the 2^{nd} channel region CH2 and a 2^{nd} side edge E2 of the 1^{st} channel region CH1 facing the 2^{nd} boundary of the 1^{st} cell C1 may be offset from each other in the D2 direction by a difference between the widths W1 and W2. Thus, the 1^{st} source/drain regions SD1 that may be epitaxially grown from the nanosheet layers of the 1^{st} channel structure CH1 may have a greater width than the 2^{nd} source/drain regions SD2 that may be epitaxially grown from the 2^{nd} channel structure CH2.

This width difference provides a region A along the 1^{st} active pattern RX1 above the 1^{st} channel structure CH1 and the 1^{st} source/drain region SD1 where the 1^{st} active pattern RX1 including the 1^{st} channel structure CH1 and the 1^{st} source/drain regions SD1 is not overlapped by the 2^{nd} active pattern RX2 including the 2^{nd} channel structure CH2 and the 2^{nd} source/drain region SD2 in the D3 direction. Due to this region A, which is a non-overlapping region, a contact structure connecting the 1^{st} source/drain regions SD1 to a metal line formed above the cell layout 10 in the D3 direction. 2

The nanosheet layers of the channel regions CH1 and CH2 may be surrounded by the gate structure PC2 and divided by a middle dielectric layer MDI. The source/drain regions SD1 and SD2 may be isolated from each other by an isolation structure ILD. Further, a backside isolation structure 101 may be formed at a backside of the 3D-stacked semiconductor device by replacing a substrate of the 3D-stacked semiconductor device. In the backside isolation structure 101, may be formed a BSPDN structure including the power rails BP1, BP2 and BP3 connected.

Based on the foregoing structure, the 1^{st} channel region CH1, the 1^{st} source/drain regions SD1, and the gate structure PC2 may form the 1^{st} transistor, which is a nanosheet transistor, at the 1^{st} level of the 3D-stacked semiconductor device, and the 2^{nd} channel region CH2, the 2^{nd} source/drain regions SD2, and the gate structure PC2 may form the 2^{nd} transistor, which is also a nanosheet transistor, at the 2^{nd} level of the 3D-stacked semiconductor device. Each of the 1^{st} transistor and the 2^{nd} transistor may be an n-type metal-oxide-semiconductor transistor (NMOS) or a p-type metal-oxide-semiconductor transistor (PMOS).

The cross-section views of the active patterns RX1 and RX2 of the filler cell FC and the 2^{nd} cell C2 taken along lines III-III' and IV-IV', respectively, may be the same as that shown in FIG. 1B except the gate structures P3 and P5 replace the gate structure P2. Further, the cross-section views of the active patterns RX1 and RX2 of the 2^{nd} cell C2 taken along lines V-V' and VI-VI' may be the same as that shown in FIG. 1C. Thus, duplicate descriptions thereof are omitted herein.

In the meantime, as described earlier, the 2^{nd} cell C2 may be disposed in the cell layout 10 by flipping the 1^{st} cell C1 in the D2 direction or rotating 180 degree. Thus, while the non-overlapping region A of the 1^{st} cell C1 faces the 2^{nd} power rail BP2 at the 2^{nd} boundary of the cell layout 10, the non-overlapping region A in the 2^{nd} cell C2 faces the 1^{st} power rail BP1 at the 1^{st} boundary of the cell layout 10.

This cell flipping may be performed in designing a cell layout when a flipped cell can shorten a signal routing path between circuit elements in the flipped cell and circuit elements in neighboring cells. The cell flipping may not be allowed in designing a cell layout for a 2D semiconductor device which limits positions of power rails respectively connected to VDD and VSS at a 1^{st} boundary and a 2^{nd} boundary (or vice versa) of a cell, respectively. However, the cell flipping can be allowed in designing a cell layout for a 3D-stacked semiconductor device like the cell layout 10 of FIG. 1A in which a BSPDN including the power rails BP1, BP2 and BP3 are formed. This is because the BSPDN is not limited by a cell design rule which limits the positions of power rails connected to opposite voltage sources at the 1^{st} boundary and the 2^{nd} boundary of a cell or cell block for a cell layout, respectively. For example, in the cell layout 10 for a 3D-stacked semiconductor device, the 1^{st} power rail BP1 and the 2^{nd} power rail BP2 connected to a same voltage source VDD or VSS may be formed at both the 1^{st} boundary and the 2^{nd} boundary of the cell layout 10, while the 3^{rd} power rail BP3 may be formed along the virtual center line of the cell layout 10 in a plan view.

When the cell flipping is applied to the cell layout 10 based on the BSPDN as shown in FIG. 1A, the filler cell FC may connect the 1^{st} cell C1 and the 2^{nd} cell C2 as described below.

For example, the 1^{st} cell C1 may be characterized in that the 1^{st} side edges E1 of the 1^{st} active pattern RX1 and the 2^{nd} active pattern RX2, extended in the D1 direction and aligned or coplanar in the D3 direction, may be distant from the 1^{st} boundary of the cell layout 10 by a distance H1 in the D2 direction. Further, the 2^{nd} cell C2, which is a flipped cell of the 1^{st} cell C1, may be characterized in that 2^{nd} side edges E2 of the 1^{st} active pattern RX1 and the 2^{nd} active pattern RX2, extended in the D1 direction and aligned or coplanar in the D3 direction, may be distant from the 2^{nd} boundary of the cell layout 10 by the same distance H1 in the D2 direction.

In this example, the 1^{st} active pattern RX1 of the filler cell FC may seamlessly connect the 1^{st} active pattern RX1 of the 1^{st} cell C1 and the 1^{st} active pattern RX1 of the 2^{nd} cell C2 such that a 1^{st} side edge E1 and a 2^{nd} side edge E2 of the 1^{st} active pattern RX1 of the filler cell FC, facing the 1^{st} boundary of the cell layout 10, are coplanar or aligned with a 1^{st} side edge E1 and a 2^{nd} side edge E2 of the 1^{st} active pattern RX1 of the 2^{nd} cell C2 also facing the 1^{st} boundary of the cell layout 10, respectively, in the D1 direction. However, the 2^{nd} active pattern RX2 of the filler cell FC may not seamlessly connect the 2^{nd} active pattern RX2 of the 1^{st} cell C1 and the 2^{nd} active pattern RX2 of the 2^{nd} cell C2, which is a flipped cell of the 1^{st} cell C1 such that a 1^{st} side edge E1 and a 2^{nd} side edge E2 of the 2^{nd} active pattern RX2 of the filler cell FC, facing the 2^{nd} boundary of the cell layout 10, are not coplanar or aligned with a 1^{st} side edge E1 and a 2^{nd} side edge E2 of the 2^{nd} active pattern RX2 of the 2^{nd} cell C2 also facing the 2^{nd} boundary of the cell layout 10, respectively, in the D1 direction. Stated another way, although the 1^{st} active pattern RX1 of the filler cell FC may entirely overlap the 1^{st} active pattern RX1 of the 2^{nd} cell C2 in the D1 direction, the 2^{nd} active pattern RX2 of the filler cell FC may not entirely overlap the 2^{nd} active pattern RX2 of the 2^{nd} cell C2 in the D1 direction because the 2^{nd} active pattern RX2 in the flipped cell, i.e., 2^{nd} cell C2, is offset from the 2^{nd} active pattern RX2 of the 1^{st} cell C1 by a distance O1 in the D1 direction.

Thus, while the 1^{st} active pattern RX1 of the 1^{st} cell C1 and the 1^{st} active pattern RX1 of the 2^{nd} cell C2 may be entirely connected at the boundary of the filler cell FC and the 2^{nd} cell C2, the 2^{nd} active pattern RX2 the filler cell FC and the 2^{nd} active pattern RX2 of the 2^{nd} cell C2 may be only partially connected at two connection corner edges CE1 and CE2 and therebetween at the boundary of the filler cell FC and the 2^{nd} cell C2.

This partial connection of the 2^{nd} active patterns RX2 in the cell layout 10 may cause a difficulty in patterning the 2^{nd} active patterns RX2 when a 3D-stacked semiconductor device is formed based on the cell layout 10. For example, when the 2^{nd} active patterns RX2 of the filler cell FC and the 2^{nd} cell C2 are patterned, the two connection corner edges CE1 and CE2 may not be perpendicularly angled as shown in FIG. 1A, and instead, may be rounded because of the difficulty in achieving the nanoscale precision. Thus, a size of the 2^{nd} active pattern RX2 of the 2^{nd} cell may be formed to be smaller or greater than the designed size, and thus, device performance of the 3D-stacked semiconductor device may not be reliable.

The filler cell mismatch in a 3D-stacked semiconductor device including a BSPDN as described above may have different forms when the size of active patterns in two connected cells and a filler cell is smaller than that shown in FIG. 1A.

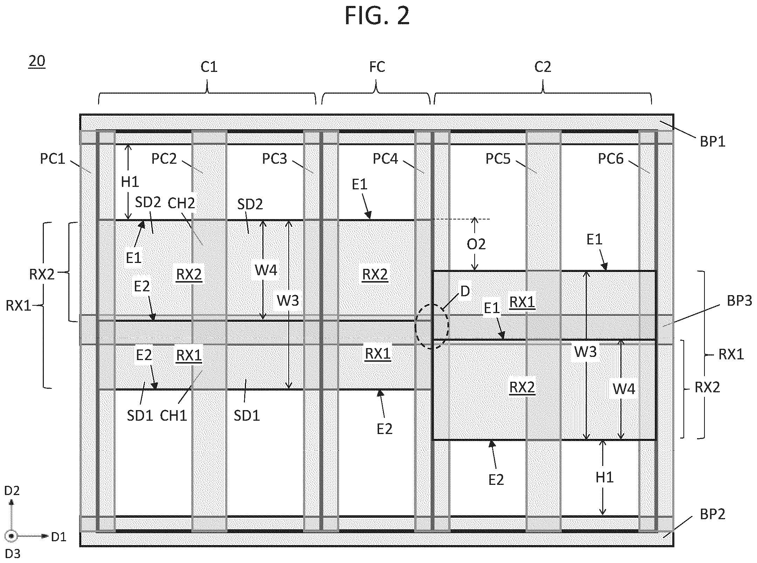

FIG. 2 illustrates a cell layout including a filler cell for a 3D-stacked semiconductor device, according to still one or more other embodiments.

Referring to FIG. 2, a cell layout 20 may have the same structural elements as those of the cell layout 10 shown in FIGS. 1A-1C, and thus, duplicate descriptions thereof are omitted herein. However, the cell layout 20 differs from the cell layout 10 in that a width W3 of a 1^{st} active pattern RX1 and a width W4 of a 2^{nd} active pattern RX2 in each of a 1^{st} cell C1, a filler cell FC and a 2^{nd} cell C2 in the cell layout 20 are 30% smaller than the width W1 of the 1^{st} active pattern RX1 and the width W2 of the 2^{nd} active pattern RX2 in the cell layout 10, respectively. Thus, while the 1^{st} cell C1 and the 2^{nd} cell C2 of the cell layout 10 may be referred to as an X1 driver, the 1^{st} cell C1 and the 2^{nd} cell C2 of the cell layout 20 may be referred to as an X0.7 driver.

However, although the widths of the active patterns RX1 and RX2 are reduced, 1^{st} side edges E1 of the active patterns RX1 and RX2 of the 1^{st} cell C1 in the cell layout 20 may be distant from a 1^{st} boundary of the cell layout 20 by the same distance H1 as in the cell layout 10. The active patterns RX1 and RX2 of the 1^{st} cell C1, even when the widths thereof are reduced, may be disposed in this manner to be close to the 1^{st} power rail BP1 at the 1^{st} boundary of the cell layout 20 at least to reduce a connection distance to the 1^{st} power rail BP1. Accordingly, when the 1^{st} cell C1 is flipped to form the 2^{nd} cell C2, 2^{nd} side edges E2 of the active patterns RX1 and RX2 of the 2^{nd} cell C2 may also be distant from a 2^{nd} boundary of the cell layout 20 by the same distance H1 to be close to the 2^{nd} power rail BP2 at the 2^{nd} boundary of the cell layout 20.

However, because of the reduced widths W3 and W4 of the active patterns RX1 and RX2, the active pattern connection of the 1^{st} cell C1 and the flipped cell, i.e., the 2^{nd} cell C2, by the filler cell FC may have a different form in the cell layout 20.

For example, unlike in the cell layout 10, even the 1^{st} active pattern RX1 of the filler cell FC in the cell layout 20 may not seamlessly connect the 1^{st} active pattern RX1 of the 1^{st} cell C1 and the 1^{st} active pattern RX1 of the 2^{nd} cell C2. Thus, the 1^{st} active pattern RX1 of the 2^{nd} cell C2 may be offset from the 1^{st} active pattern RX1 of the filler cell FC by a distance O2 in the D2 direction, and the 1^{st} active patterns RX1 of the filler cell FC may partially overlap the 1^{st} active pattern RX1 of the 2^{nd} cell C2 in the D1 direction in the cell layout 20.

As discussed earlier about the cell layout 10, the partial connection of the 1^{st} active patterns RX2 in the cell layout 20 may cause a difficulty in patterning the 1^{st} active patterns RX1 when a 3D-stacked semiconductor device is formed based on the cell layout 20, and may lower reliability of device performance of the 3D-stacked semiconductor device. However, the partial connection may still maintain continuity of the 1^{st} active patterns RX1 between the three cells C1, FC and C2 in the cell layout 20.

However, the 2^{nd} active pattern RX2 of the filler cell FC may be disconnected in the D2 direction from the 2^{nd} active pattern RX2 of the 2^{nd} cell C2 at a region D as shown in FIG. 2. Thus, the disconnection of the 2^{nd} active patterns RX2 in the cell layout 20 may negate the primary purpose of the filler cell FC including maintaining continuity of the 2^{nd} active patterns RX2 in the two cells C1 and C2. Further, the disconnection of the 2^{nd} active patterns RX2 may complicate or obstruct patterning of the 2^{nd} active patterns RX2 in manufactured a 3D-stacked semiconductor device based on the cell layout 20. Moreover, the disconnection of the 2^{nd} active patterns RX2 may increase parasitic capacitance and resistance, and thus, a risk of malfunction in the 3D-stacked semiconductor device may increase.

The filler cell mismatch in a 3D-stacked semiconductor device including a BSPDN may be greater when the size of active patterns in two connected cells and a filler cell is smaller than that shown in FIG.2.

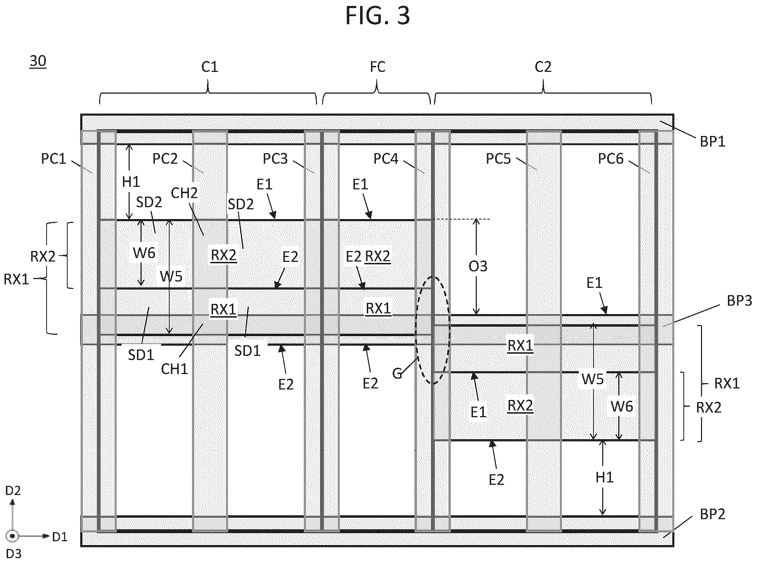

FIG. 3 illustrates a cell layout including a filler cell for a 3D-stacked semiconductor device, according to yet one or more other embodiments.

Referring to FIG. 3, a cell layout 30 may have the same structural elements as those of the cell layout 10 shown in FIGS. 1A-1C, and thus, duplicate descriptions thereof are omitted herein. However, the cell layout 30 differs from the cell layout 10 in that a width W5 of a 1^{st} active pattern RX1 and a width W6 of a 2^{nd} active pattern RX2 in each of a 1^{st} cell C1, a filler cell FC and a 2^{nd} cell C2 in the cell layout 30 are 50% smaller than the width W1 of the 1^{st} active pattern RX1 and the width W2 of the 2^{nd} active pattern RX2 in the cell layout 10, respectively. Thus, while the 1^{st} cell C1 and the 2^{nd} cell C2 of the cell layout 10 may be referred to as the X1 driver, and the 1^{st} cell C1 and the 2^{nd} cell C2 of the cell layout 20 may be referred to as the X0.7 driver, the 1^{st} cell C1 and the 2^{nd} cell C2 of the cell layout 20 may be referred to as an X0.5 driver.

However, although the respective widths W1 and W2 of the active patterns RX1 and RX2 are reduced, 1^{st} side edges E1 of the active patterns RX1 and RX2 of the 1^{st} cell C1 may be distant from a 1^{st} boundary of the cell layout 30 by the same distance H1 as in the cell layouts 10 and 20 for the same reason described above for the cell layout 20. Thus, 2^{nd} side edges E2 of the active patterns RX1 and RX2 of the 2^{nd} cell C2 may also be distant from a 2^{nd} boundary of the cell layout 30 by the same distance H1 to be close to the 2^{nd} power rail BP2 at the 2^{nd} boundary of the cell layout 30.

Like in the cell layout 20, the reduced widths W5 and W6 of the active patterns RX1 and RX2 in the cell layout 30 may cause the active pattern connection of the 1^{st} cell C1 and the flipped cell, i.e., the 2^{nd} cell C2, by the filler cell FC to have a different form.

For example, like in the cell layout 20 of FIG. 2, the 1^{st} active pattern RX1 of the filler cell FC may not seamlessly connect the 1^{st} active pattern RX1 of the 1^{st} cell C1 and the 1^{st} active pattern RX1 of the 2^{nd} cell C2. Thus, the 1^{st} active pattern RX1 of the 2^{nd} cell C2 may be offset from the 1^{st} active pattern RX1 of the filler cell FC by a distance O3 in the D2 direction., and the 1^{st} active patterns RX1 of the filler cell FC may partially overlap the 1^{st} active pattern RX1 of the 2^{nd} cell C2 in the D1 direction. However, the offset distance O3 of the 1^{st} active pattern RX1 of the 2^{nd} cell C2 in the cell layout 30 may be greater than the offset distance O2 of the 1^{st} active pattern RX1 of the 2^{nd} cell C2 in the cell layout 20. Thus, the 1^{st} active pattern RX1 of the filler cell FC may be barely connected to the 1^{st} active pattern RX1 of the 2^{nd} cell C2.

Moreover, the 2^{nd} active pattern RX2 of the filler cell FC may be further disconnected in the D2 direction from the 2^{nd} active pattern RX2 of the 2^{nd} cell C2 at a region G as shown in FIG. 3, compared to the 2^{nd} cell layout 20 in FIG. 2. Like in the cell layout 20, the disconnection of the 2^{nd} active patterns RX2 in the cell layout 20 may negate the primary purpose of the filler cell FC including maintaining continuity of the 2^{nd} active patterns RX2 in the two cells C1 and C2. Further, the disconnection of the 2^{nd} active patterns RX2 may complicate or obstruct patterning of the 2^{nd} active patterns RX2 when a 3D-stacked semiconductor device is formed based on the cell layout 30. Moreover, the disconnection of the 2^{nd} active patterns RX2 in the cell layout 30 may also increase parasitic capacitance and resistance, and thus, a risk of malfunction in the 3D-stacked semiconductor device may increase.

In order to address at least the disconnection of the 2^{nd} active patterns RX2 in the cell layouts 20 and 30, the following embodiments provide an improved filler cell for a cell layout for a 3D-stacked semiconductor device.

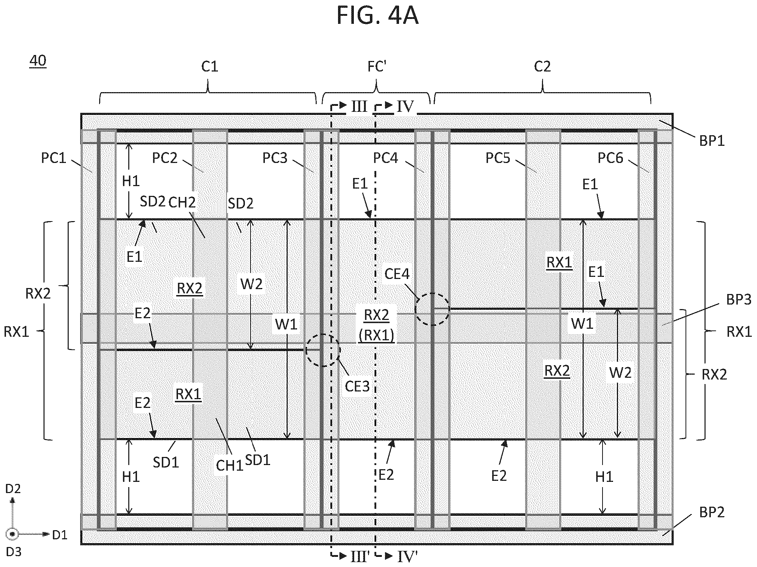

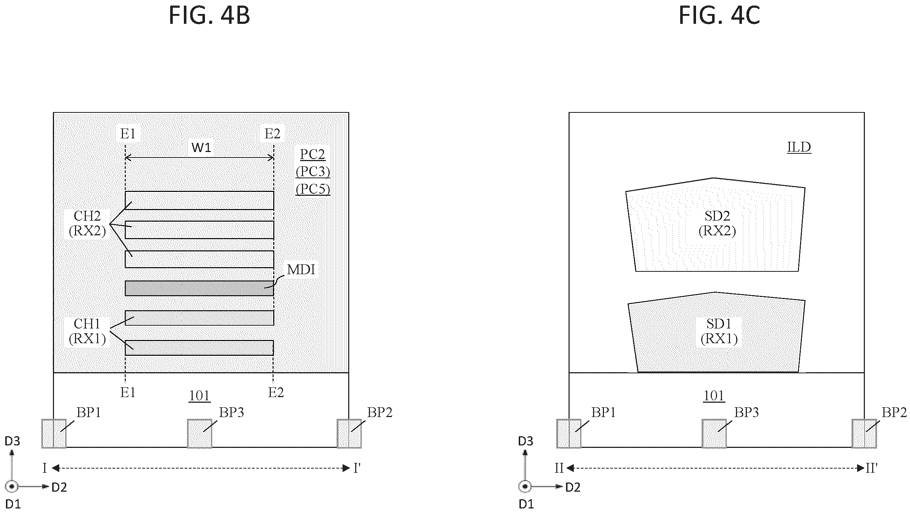

FIG. 4A illustrates a cell layout including a uniform filler cell for a 3D-stacked semiconductor device, according to one or more embodiments. FIGS. 4B and 4C illustrate cross-section views of the 3D-stacked semiconductor device manufactured based on the cell layout of FIG. 4A along lines III-III' and IV-IV' shown in FIG. 4A, respectively, according to one or more embodiments.

Referring to FIGS. 4A-4C, a cell layout 40 may have the same structural elements as those of the cell layout 10 shown in FIGS. 1A-1C, and each of a 1^{st} cell C1 and a 2^{nd} cell C2, which is a flipped cell of the 1^{st} cell C1, may be an X1 driver. Thus, duplicate descriptions thereof may be omitted herein.

In the cell layout 40, like in the cell layout 10, the 1^{st} active patterns RX1 of a 1^{st} cell C1, the filler cell FC and a 2^{nd} cell C2 may entirely overlap in the D1 direction such that 1^{st} side edges E1 thereof may be aligned with or coplanar in the D1 direction and 2^{nd} side edges E2 thereof may also be aligned with or coplanar in the D1 direction.

However, a filler cell FC' included in the cell layout 40 may be a uniform filler cell in which a 2^{nd} active pattern RX2 has the same width W1 as the 1^{st} active pattern RX1, while the 2^{nd} active pattern RX2 in the cell layout 10 has the width W2 which is smaller than the width W1 of the 1^{st} active pattern RX1 therein. Thus, the filler cell FC' in the cell layout 40 may have cross-section views shown in FIGS. 4B and 4C taken along lines III-III' and IV-IV' of FIG. 4A. Referring to FIGS. 4B and 4C, a 1^{st} channel region CH1 and a 2^{nd} channel region CH2 of the filler cell FC' above the 1^{st} channel region CH1 may have the same width W1, and a 1^{st} source/drain region SD1 and a 2^{nd} source/drain region SD2 may also have a same width although the two source/drain regions SD1 and SD2 may not be connected to a voltage source for power delivery or any other circuit element for signal routing purpose.

Thus, in the cell layout 40, the width W1 of the 2^{nd} active pattern RX2 of the filler cell FC' may be greater than a width W2 of each of the 2^{nd} active pattern RX2 of the 1^{st} cell C1 and the 2^{nd} active pattern RX2 of the 2^{nd} cell C2. Further, while 1^{st} side edges E1 of the 2^{nd} active patterns RX2 of the 1^{st} cell C1 and the filler cell FC' are aligned or coplanar in the D1 direction, 2^{nd} side edges E2 of the 2^{nd} active patterns RX2 of the 1^{st} cell C1 and the filler cell FC' may not be aligned or coplanar in the D1 direction. Similarly, while 2^{nd} side edges E2 of the 2^{nd} active patterns RX2 of the 2^{nd} cell C2 and the filler cell FC' are aligned or coplanar in the D1 direction, 1^{st} side edges E1 of the 2^{nd} active patterns RX2 of the 2^{nd} cell C2 and the filler cell FC' may not be aligned or coplanar in the D1 direction. Thus, each of the 2^{nd} active pattern RX2 of the 1^{st} cell C1 and the 2^{nd} active pattern RX2 of the 2^{nd} cell C2 may be entirely overlapped by the 2^{nd} active pattern RX2 of the filler cell FC.

In the meantime, the 2^{nd} side edge E2 of the 2^{nd} active pattern RX2 of the 1^{st} cell C1 may be connected to the 2^{nd} active pattern RX2 of the filler cell FC' at a connection corner edge CE3, and the 1^{st} side edge E1 of the 2^{nd} active pattern RX2 of the 2^{nd} cell C2 may be connected to the 2^{nd} active pattern RX2 of the filler cell FC' at a connection corner edge CE4. Thus, similar to the connection corner edges CE1 and CE2 in the cell layout 10 of FIG. 1A, the connection corner edges CE3 and CE4 in the cell layout 40 may also cause patterning difficulties in manufacturing a 3D-stacked semiconductor device based on the cell layout 40, which may affect device performance of the 3D-stacked semiconductor device.

Still, however, the 2^{nd} active pattern RX2 of the filler cell FC of the cell layout 40 may provide a greater connection surface to the 2^{nd} active patterns RX2 of the 1^{st} cell C1 and the 2^{nd} cell C2, thereby to reduce the manufacturing difficulties compared to the cell layout 10.

In the meantime, the filler cell FC' formed to connect the 1^{st} cell C1 and the 2^{nd} cell C2, which are each an X1 driver, in the cell layout 10 may be formed to connect two cells which are each an X0.75 driver or X0.5 driver as described below.

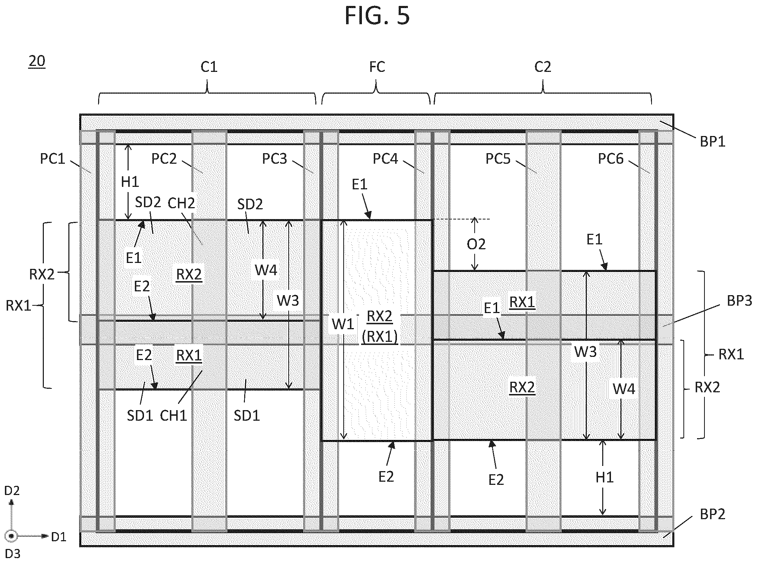

FIG. 5 illustrates a cell layout including a uniform filler cell for a 3D-stacked semiconductor device, according to still one or more other embodiments.

Referring to FIG. 5, a cell layout 50 may have the same structural elements as those of the cell layout 20 shown in FIG. 2, and each of a 1^{st} cell C1 and a 2^{nd} cell C2 may be an X0.7 driver of which a 1^{st} active pattern RX1 and a 2^{nd} active pattern RX2 have a 30% smaller width than those of the 1^{st} cell C1 and the 2^{nd} cell C2 of the cell layout 40, each of which is an X1 driver. Thus, duplicate descriptions thereof may be omitted herein.

However, the cell layout 50 may differ from the cell layout 20 in that the filler cell FC' connecting the two cells C1 and C2, which are X1 drivers, in the cell layout 40 is formed in the cell layout 50 to connect the two cells C1 and C2 therein which are X0.7 drivers. Thus, in the cell layout 50, the width W3 of the 1^{st} active pattern RX1 and the width W4 of the 2^{nd} active pattern RX2 of each of the two cells C1 and C2 may be smaller than the width W1 of each of the 1^{st} active pattern RX1 and the 2^{nd} active pattern RX2 of the filler cell FC'.

Because of this width difference between the filler cell FC' and each of the two cells C1 and C2 in the cell layout 50, the 1^{st} active pattern RX1 of each of the two cells C1 and C2 may be entirely overlapped by the 1^{st} active pattern RX1 of the filler cell FC' in the D1 direction. Moreover, the 2^{nd} active pattern RX2 of each of the two cells C1 and C2 may be entirely overlapped by the 2^{nd} active pattern RX2 of the filler cell FC' in the D1 direction. Further, 1^{st} side edges E1 of the two active patterns RX1 and RX2 of the 1^{st} cell C1 and the filler cell FC' are coplanar and aligned in the D1 direction, and 2^{nd} side edges E2 of the two active patterns RX1 and RX2 of the 2^{nd} cell C2 and the filler cell FC' are coplanar and aligned in the D1 direction.

Due to the greater width of the 2^{nd} active pattern RX2 of the filler cell FC', the 2^{nd} active pattern RX2 of the 2^{nd} cell C2 cannot be disconnected from the 2^{nd} active pattern RX2 of the filler cell FC' in the cell layout 50, unlike in the cell layout 20 where the two active patterns RX1 and RX2 of the filler cell FC have the same widths as the two active patterns RX1 and RX2 of each of the two cells C1 and C2, respectively, whereby the 2^{nd} active patterns RX2 of the filler cell FC and the 2^{nd} cell C2 are disconnected. Thus, a 3D-stacked semiconductor device may be manufactured based on the cell layout 50 without patterning disruption that may occur in manufacturing a 3D-stacked semiconductor device based on the cell layout 20 because of the disconnection in the 2^{nd} active patterns RX2 between the filler cell FC and the 2^{nd} cell C2.

The filler cell FC' in the cell layouts 40 and 50 for the X1 driver and the X0.7 driver may also be formed in a cell layout for a X0.5 driver as described below.

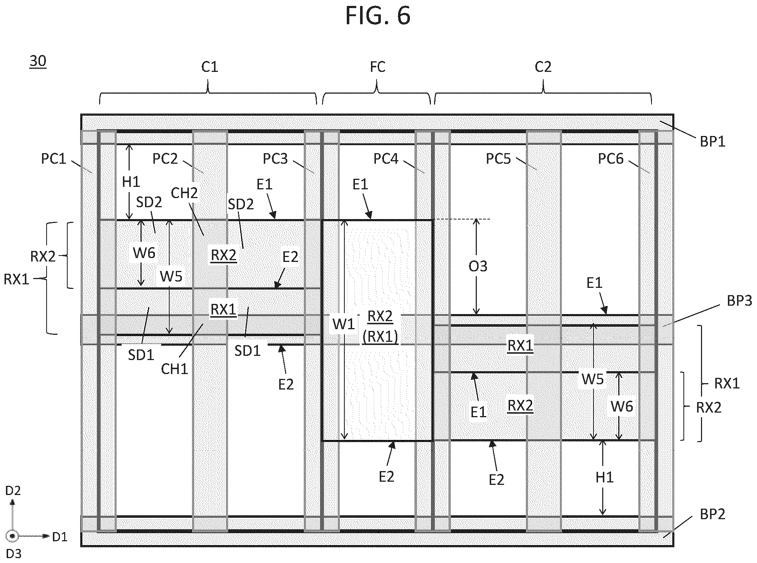

FIG. 6 illustrates a cell layout including a uniform filler cell for a 3D-stacked semiconductor device, according to yet one or more other embodiments.

Referring to FIG. 6, a cell layout 60 may have the same structural elements as those of the cell layout 30 shown in FIG. 3, and each of a 1^{st} cell C1 and a 2^{nd} cell C2 may be an X0.5 driver of which a 1^{st} active pattern RX1 and a 2^{nd} active pattern RX2 have a 50% smaller width than those of the 1^{st} cell C1 and the 2^{nd} cell C2 of the cell layout 40, each of which is an X1 driver. Thus, duplicate descriptions thereof may be omitted herein.

However, the cell layout 60 may differ from the cell layout 30 in that the filler cell FC' connecting the two cells C1 and C2, which are an X1 driver, in the cell layout 40 is formed in the cell layout 60 to connect the two cells C1 and C2 therein which are an X0.5 driver. Thus, in the cell layout 60, the width W5 of the 1^{st} active pattern RX1 and the width W6 of the 2^{nd} active pattern RX2 of each of the 1^{st} cell C1 and the 2^{nd} cell C2 may be smaller than the width W1 of each of the 1^{st} active pattern RX1 and the 2^{nd} active pattern RX2 of the filler cell FC'.

Because of this width difference between the filler cell FC' and each of the two cells C1 and C2 in the cell layout 60, the 1^{st} active pattern RX1 of each of the two cells C1 and C2 may be entirely overlapped by the 1^{st} active pattern RX1 of the filler cell FC' in the D1 direction. Moreover, the 2^{nd} active pattern RX2 of each of the two cells C1 and C2 may be entirely overlapped by the 2^{nd} active pattern RX2 of the filler cell FC' in the D1 direction. Further, 1^{st} side edges E1 of the two active patterns RX1 and RX2 of the 1^{st} cell C1 and the filler cell FC' are coplanar and aligned in the D1 direction, and 2^{nd} side edges E2 of the two active patterns RX1 and RX2 of the 2^{nd} cell C2 and the filler cell FC' are coplanar and aligned in the D1 direction.

Due to the greater width of the 2^{nd} active pattern RX2 of the filler cell FC', the 2^{nd} active pattern RX2 of the 2^{nd} cell C2 cannot be disconnected from the 2^{nd} active pattern RX2 of the filler cell FC' in the cell layout 60, unlike in the cell layout 30 where the two active patterns RX1 and RX2 of the filler cell FC have the same widths as the two active patterns RX1 and RX2 of each of the two cells C1 and C2, respectively, whereby the 2^{nd} active patterns RX2 of the filler cell FC and the 2^{nd} cell C2 are disconnected. Thus, a 3D-stacked semiconductor device may be manufactured based don the cell layout 60 without patterning disruption that may occur in manufacturing a 3D-stacked semiconductor device based on the cell layout 30 because of the disconnection in the 2^{nd} active patterns RX2 between the filler cell FC and the 2^{nd} cell C2.

In the above embodiments, the 1^{st} active pattern RX1 is formed to have a smaller width than the 2^{nd} active pattern RX2 in each of the 1^{st} cell C1 and the 2^{nd} cell C2 of each of the cells 10-60 so that the 1^{st} source/drain region SD1 formed on the 1^{st} active pattern RX1 may have the non-overlapping region A for the formation of a contact structure on the top surface of the 1^{st} source/drain region. However, the disclosure is not limited thereto. According to one or more other embodiments, the 1^{st} active pattern RX1 may be formed to have a same width as the 2^{nd} active pattern RX2 in each of the 1^{st} cell C1 and the 2^{nd} cell C2 of each of the cells 10-60.

In the above embodiments, the transistors formed in each of the 1^{st} cell C1, the filler cells FC and FC' and the 2^{nd} cell C2 in each of the cell layouts 10-60 are a nanosheet transistor as shown in FIGS. 1B, 1C, 4B and 4C. However, the disclosure is not limited thereto. According to one or more other embodiments, each of the transistors may be a different type of transistor such as FinFET, forksheet transistor, etc., not being limited thereto.

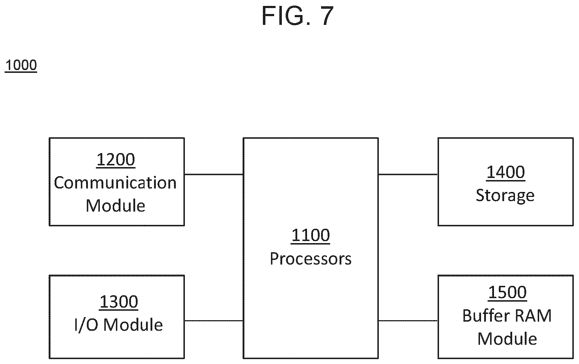

FIG. 7 is a schematic block diagram illustrating an electronic device including at least one 3D-stacked semiconductor device formed based on at least one of the cell layouts or cell blocks 40, 50 and 60 shown in FIGS. 4A, 5 and 6, respectively, according to one or more embodiments.

Referring to FIG. 7, an electronic device 1000 may include at least one processor 1100, a communication module 1200, an input/output module 1300, a storage 1400, and a buffer random access memory (RAM) module 1500. The electronic device 1000 may be a mobile device such as a smartphone or a tablet computer, not being limited thereto, according to embodiments.

The processor 1100 may include a central processing unit (CPU), a graphic processing unit (GPU) and/or any other processors that control operations of the electronic device 1000. The communication module 1200 may be implemented to perform wireless or wire communications with an external device. The input/output module 1300 may include at least one of a touch sensor, a touch panel a key board, a mouse, a proximate sensor, a microphone, etc. to receive an input, and at least one of a display, a speaker, etc. to generate an output signal processed by the processor 1100. The storage 1400 may be implemented to store user data input through the input/output module 1300, the output signal, etc. The storage 1400 may be an embedded multimedia card (eMMC), a solid state drive (SSD), a universal flash storage (UFS) device, etc.

The buffer RAM module 1500 may temporarily store data used for processing operations of the electronic device 1000. For example, the buffer RAM 1500 may include a volatile memory such as double data rate (DDR) synchronous dynamic random access memory (SDRAM), low power double data rate (LPDDR) SDRAM, graphics double data rate (GDDR) SDRAM, Rambus dynamic random access memory (RDRAM), etc.

Although not shown in FIG. 7, the electronic device 1000 may further include at least one sensor such as an image sensor.

At least one component in the electronic device 1000 may be formed based on at least one 3D-stacked semiconductor device formed based on at least one of the cell layouts or cell blocks 40, 50 and 60 shown in FIGS. 4A, 5 and 6, respectively, according to one or more embodiments.

The foregoing is illustrative of example embodiments and is not to be construed as limiting the disclosure. Although a few example embodiments have been described, those skilled in the art will readily appreciate that many modifications are possible in the above embodiments without materially departing from the disclosure.

## Claims

1. A cell layout for a semiconductor device, comprising:
a 1^{st} cell;
a 2^{nd} cell at a side of the 1^{st} cells in a 1^{st} direction; and
a filler cell between the 1^{st} cell and the 2^{nd} cell,
wherein the 2^{nd} cell has a form of a flipped cell of the 1^{st} cell in a 2^{nd} direction which intersects the 1^{st} direction,
wherein each of the 1^{st} cell, the filler cell, and the 2^{nd} cell comprises a 1^{st} active pattern and a 2^{nd} active pattern above the 1^{st} active pattern in a 3^{rd} direction which intersects the 1^{st} direction and the 2^{nd} direction,
wherein the 2^{nd} active pattern of the 1^{st} cell and the 2^{nd} active pattern of the 2^{nd} cell are partially overlapped or not overlapped in the 1^{st} direction, and
wherein each of the 2^{nd} active pattern of the 1^{st} cell and the 2^{nd} active pattern of the 2^{nd} cell is entirely overlapped by the 2^{nd} active pattern of the filler cell in the 1^{st} direction.

2. The cell layout of claim 1, further comprising at least one power rail below a level of a bottom surface of the 1^{st} active pattern in the 3^{rd} direction.

3. The cell layout of claim 1 or 2, further comprising:
a 1^{st} power rail, at a 1^{st} boundary of the cell layout, below a level of a bottom surface of the 1^{st} active pattern in the 3^{rd} direction; and
a 2^{nd} power rail, at a 2^{nd} boundary of the cell layout, below the level of the bottom surface of the 1^{st} active pattern in the 3^{rd} direction,
wherein a distance between the 1^{st} power rail and the 2^{nd} active pattern of the 1^{st} cell is the same as a distance between the 2^{nd} power rail and the 2^{nd} active pattern of the 2^{nd} cell.

4. The cell layout of claim 3, further comprising a 3^{rd} power rail between the 1^{st} power rail and the 2^{nd} power rail in the 2^{nd} direction, below the level of the bottom surface of the 1^{st} active pattern in the 3^{rd} direction.

5. The cell layout of any one of claims 1 to 4, wherein, in each of the 1^{st} cell, the filler cell, and the 2^{nd} cell, the 2^{nd} active pattern partially overlaps the 1^{st} active pattern in the 3^{rd} direction.

6. The cell layout of any one of claims 1 to 5, wherein the 1^{st} active pattern and the 2^{nd} active pattern in the filler cell have a same width in the 2^{nd} direction.

7. The cell layout of any one of claims 1 to 6, wherein a 1^{st} side edge of the 2^{nd} active pattern of the filler cell facing a 1^{st} boundary of the cell layout is coplanar or aligned with a 1^{st} side edge of the 2^{nd} active pattern of the 1^{st} cell facing the 1^{st} boundary, in the 1^{st} direction, and is not coplanar or aligned with a 1^{st} side edge of the 2^{nd} active pattern of the 2^{nd} cell facing the 1^{st} boundary, and
wherein a 2^{nd} side edge of the 2^{nd} active pattern of the filler cell facing a 2^{nd} boundary, opposite to the 1^{st} boundary, of the cell layout is coplanar or aligned with a 2^{nd} side edge of the 2^{nd} active pattern of the 2^{nd} cell facing the 2^{nd} boundary, in the 1^{st} direction, and is not coplanar or aligned with a 2^{nd} side edge of the 2^{nd} active pattern of the 1^{st} cell facing the 2^{nd} boundary.

8. The cell layout of any one of claims 1 to 7, wherein the 1^{st} active patterns of the 1^{st} cell, the filler cell and the 2^{nd} cell have a same width in the 2^{nd} direction.

9. A cell layout for a semiconductor device, comprising:
a 1^{st} cell;
a 2^{nd} cell at a side of the 1^{st} cells in a 1^{st} direction; and
a filler cell between the 1^{st} cell and the 2^{nd} cell,
wherein each of the 1^{st} cell, the filler cell, and the 2^{nd} cell comprises a 1^{st} active pattern and a 2^{nd} active pattern above the 1^{st} active pattern in a 3^{rd} direction which intersects the 1^{st} direction, and
wherein a width the 2^{nd} active pattern in the filler cell is greater than each of a width of the 2^{nd} active pattern in the 1^{st} cell and a width of the 2^{nd} active pattern in the 2^{nd} cell, in a 2^{nd} direction intersecting the 1^{st} direction and the 3^{rd} direction.

10. The cell layout claim 9, wherein a width the 1^{st} active pattern in the filler cell is greater than or equal to each of a width of the 1^{st} active pattern in the 1^{st} cell and a width of the 1^{st} active pattern in the 1^{st} cell, in the 2^{nd} direction.

11. The cell layout of claim 9 or 10, wherein the 2^{nd} cell has a form of a flipped cell of the 1^{st} cell in the 2^{nd} direction.

12. The cell layout of claim 11, further comprising at least one power rail below a level of a bottom surface of the 1^{st} active pattern in the 3^{rd} direction.

13. The cell layout of any one of claims 10 to 12, wherein a width the 1^{st} active pattern in the filler cell is greater than or equal to each of a width of the 1^{st} active pattern in the 1^{st} cell and a width of the 1^{st} active pattern in the 2^{nd} cell, in the 2^{nd} direction.

14. The cell layout of any one of claims 10 to 13, wherein the 2^{nd} active pattern of the 1^{st} cell and the 2^{nd} active pattern of the 2^{nd} cell are partially overlapped or not overlapped in the 1^{st} direction.

15. The cell layout of any one of claims 10 to 14, wherein, in each of the 1^{st} cell, the filler cell, and the 2^{nd} cell, the 2^{nd} active pattern partially overlaps the 1^{st} active pattern in the 3^{rd} direction.
